(19) Europäisches Patentamt European Patent Office Office européen des brevets

(11) **EP 2 165 190 B1**

(12) **EUROPEAN PATENT SPECIFICATION**

(45) Date of publication and mention
of the grant of the patent:
**14.09.2011 Bulletin 2011/37**

(51) Int Cl.:
**G01N 27/72** *(2006.01)*    **G01N 33/543** *(2006.01)*
**G01R 33/04** *(2006.01)*

(21) Application number: **08778195.1**

(86) International application number:
**PCT/JP2008/062778**

(22) Date of filing: **09.07.2008**

(87) International publication number:
**WO 2009/008545 (15.01.2009 Gazette 2009/03)**

(54) **MAGNETIC DETECTION ELEMENT AND DETECTION METHOD**

MAGNETISCHES DETEKTIONSELEMENT UND DETEKTIONSVERFAHREN

ELÉMENT DE DÉTECTION MAGNÉTIQUE ET PROCÉDÉ DE DÉTECTION

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **09.07.2007 JP 2007179636**

(43) Date of publication of application:
**24.03.2010 Bulletin 2010/12**

(73) Proprietor: **Canon Kabushiki Kaisha
Tokyo 146-8501 (JP)**

(72) Inventors:
• **UEDA, Miki
Tokyo (JP)**
• **IKEDA, Takashi
Tokyo (JP)**

(74) Representative: **Weser, Thilo
Weser & Kollegen
Patentanwälte
Radeckestrasse 43
81245 München (DE)**

(56) References cited:
WO-A-01/40790    WO-A-2007/014322
WO-A-2007/042958    DE-A1- 10 035 600
US-A- 3 643 155    US-A1- 2005 244 987
US-B1- 6 736 978

• CHIRIAC H ET AL: "Magnetic GMI sensor for detection of biomolecules" JOURNAL OF MAGNETISM AND MAGNETIC MATERIALS, ELSEVIER SCIENCE PUBLISHERS, AMSTERDAM, NL, vol. 293, no. 1, 1 May 2005 (2005-05-01), pages 671-676, XP004883046 ISSN: 0304-8853 cited in the application
• ANDO B ET AL: "RTD Fluxgate performance for application in magnetic label-based bioassay: preliminary results" ENGINEERING IN MEDICINE AND BIOLOGY SOCIETY, 2006. EMBS '06. 28TH ANNUAL INTERNATIONAL CONFERENCE OF THE IEEE, IEEE, PISCATAWAY, NJ, USA, 30 August 2006 (2006-08-30), pages 5060-5063, XP031236665 ISBN: 978-1-4244-0032-4
• TANG J ET AL: "Giant magnetoresistance, structural and magnetic properties of glass-coated Fe-Ni-Cu microwires" JOURNAL OF MAGNETISM AND MAGNETIC MATERIALS, ELSEVIER SCIENCE PUBLISHERS, AMSTERDAM, NL, vol. 249, no. 1-2, 1 August 2002 (2002-08-01), pages 73-78, XP004389890 ISSN: 0304-8853
• ANDO ET AL: "''Residence times difference'' fluxgate" MEASUREMENT, INSTITUTE OF MEASUREMENT AND CONTROL. LONDON, GB, vol. 38, no. 2, 1 September 2005 (2005-09-01), pages 89-112, XP005029251 ISSN: 0263-2241
• CARMAN G P ET AL: "Dynamic Magnetomechanical Behavior of Terfenol-D/ Epoxy 1-3 Particulate Composites" IEEE TRANSACTIONS ON MAGNETICS, IEEE SERVICE CENTER, NEW YORK, NY, US, vol. 40, no. 1, 1 January 2004 (2004-01-01), pages 71-77, XP011106756 ISSN: 0018-9464

- RICHARDSON J ET AL: "A novel measuring system for the determination of paramagnetic particle labels for use in magneto-immunoassays" BIOSENSORS & BIOELECTRONICS, ELSEVIER SCIENCE PUBLISHERS, BARKING, GB, vol. 16, no. 9-12, 1 December 2001 (2001-12-01), pages 1127-1132, XP002334352 ISSN: 0956-5663 cited in the application
- FERREIRA H A ET AL: "Biodetection using magnetically labeled biomolecules and arrays of spin valve sensors (invited)" JOURNAL OF APPLIED PHYSICS, AMERICAN INSTITUTE OF PHYSICS. NEW YORK, US, vol. 93, no. 10, 15 May 2003 (2003-05-15), pages 7281-7286, XP012058127 ISSN: 0021-8979 cited in the application
- CARR C ET AL: "Magnetic Sensors for Bioassay: HTS SQUIDs or GMRs?" IEEE TRANSACTIONS ON APPLIED SUPERCONDUCTIVITY, IEEE SERVICE CENTER, LOS ALAMITOS, CA, US, vol. 17, no. 2, 1 June 2007 (2007-06-01), pages 808-811, XP011188120 ISSN: 1051-8223
- BESSE PIERRE-A ET AL: "Detection of a single magnetic microbead using a miniaturized silicon Hall sensor" APPLIED PHYSICS LETTERS, AIP, AMERICAN INSTITUTE OF PHYSICS, MELVILLE, NY, vol. 80, no. 22, 3 June 2002 (2002-06-03), pages 4199-4201, XP012031095 ISSN: 0003-6951 cited in the application
- LEE SEUNGKYUN ET AL: "Magnetic gradiometer based on a high-transition temperature superconducting quantum interference device for improved sensitivity of a biosensor" APPLIED PHYSICS LETTERS, AIP, AMERICAN INSTITUTE OF PHYSICS, MELVILLE, NY, vol. 81, no. 16, 14 October 2002 (2002-10-14), pages 3094-3096, XP012032234 ISSN: 0003-6951 cited in the application
- PHAN ET AL: "Giant magnetoimpedance materials: Fundamentals and applications" PROGRESS IN MATERIALS SCIENCE, PERGAMON PRESS, GB, vol. 53, no. 2, 1 February 2008 (2008-02-01), pages 323-420, XP022492050 ISSN: 0079-6425

**Description**

TECHNICAL FIELD

The present invention relates to a magnetic detection element for detecting a magnetic particle or a non-magnetic substance labeled with a magnetic particle, and relates also to a method for magnetic detection.

BACKGROUND ART

Radio immunoassay (RIA) or immunoradiometric assay (IRMA) are known as quantitative immunoassay since a long time ago. In these assay methods, an affinitive antigen (or antibody) is labeled with a radioactive nuclide, and a target substance (antibody or antigen) is assayed indirectly by measurement of the specific radioactivity. This assay method is useful for clinical diagnosis owing to the high sensitivity. However, this method requires security against the radioactive nucleotide, and requires a facility or apparatus for handling the radioactive nucleotide. Therefore, simpler and safer methods other than the radiometric method are proposed which utilize a label such as a fluorescent substance, an enzyme, an electrochemical luminescent molecule, a magnetic particle, and so forth.

In assaying with label such as a fluorescent label, an enzyme label, or an electrochemical luminescent label, the target substance is detected by measuring an optical property such as light absorbance, light transmittance, and emitted light quantity. In an enzyme immunoassay method (EIA) with an enzyme as the label, an antigen-antibody reaction is caused, an enzyme-labeled antibody is allowed to react with a substrate for the enzyme to develop a color, and the light absorbance is measured quantitatively by colorimetry.

Some research reports on biosensors employing a magnetic sensor element are presented by several research institutes. The magnetic biosensor detects indirectly a biological molecule labeled with a magnetic particle. The magnetic sensor elements include magnetoresistive elements, Hall elements, Josephson elements, coil elements, magnetic impedance-variable elements, and flux gate (FG) sensors.

(Japanese Patent Application Laid-Open Nos. 2005-315744 (Patent Document 1); 2006-208368 (Patent Document 2); H. A. Ferreira, et al., J. Appl. Phys., 93 7281 (2003), (Non-Patent Document 1); Pierre-A. Besse, et al., Appl. Phys. Lett. 80 4199 (2002), (Non-Patent Document 2); SeungKyun Lee, et al., Appl. Phys. Lett. 81 3094 (2002) (Non-Patent Document 3); Richard Luxton, et al., Anal. Chem. 16 1127 (2001) (Non-Patent Document 4); and Horia Chiriac, et al., J. Magn. Magn. Mat. 293 671 (Non-Patent Document 5)

The FG sensor detects an induced electromotive force with a soft magnetic member and a coil. The detection method employing the above elements for detection of a biological substance have respectively features. Among them, FC sensor has advantages of high resolution of the magnetic field, high linearity of the output for the applied magnetic field, and high stability to temperature.

The FG sensors are classified roughly into two types: parallel type sensors, and orthogonal type sensors. The parallel type FG sensor generally includes a soft magnetic core, an exciting coil for applying an alternating magnetic field to the core, and a detecting coil for detecting a magnetic change in the core. With this sensor, a magnetic field is detected by utilizing a change of the magnetic flux resulting from a magnetic change in the soft magnetic core in the alternate magnetic field, Hac. ("Zikikohgaku no Kiso to Oyoh": Denki Gakkai magnetics Technology Committee p.171 ("Base and Application of Magnetic Engineering": The Institute of Electrical Engineers of Japan, Magnetics Technology Committee: p.171 (Non-Patent Document 6)).

Fig. 13 illustrates a constitution of a typical parallel type of FG sensor element. In Fig. 13, the sensor detects the magnetic field in the longitudinal direction of detection coils 1250, 1260. As illustrated in the drawing, the parallel type FG sensor element is placed in the external magnetic field $H_0$ (magnetic filed to be detected) in the longitudinal direction of detection coil 1250, 1260 parallel thereto. An alternating magnetic field Hac is applied to soft magnetic core 1200 with exciting coil 1230.

Fig. 14 is a drawing for describing the operation principle of the FC sensor element.

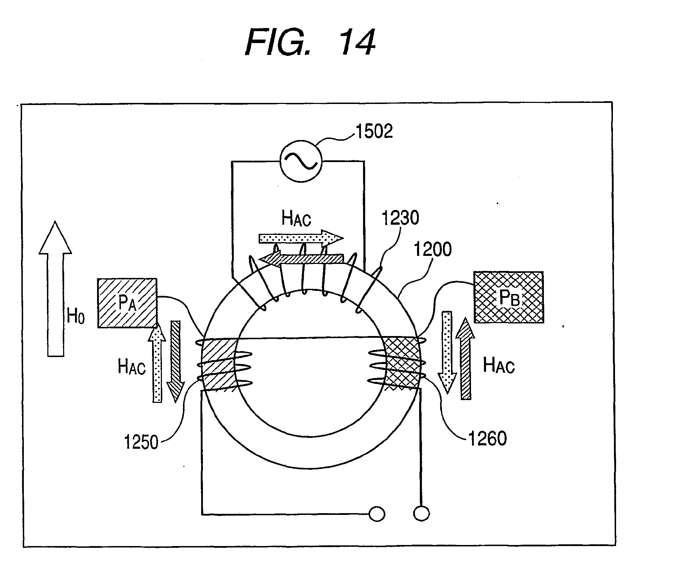

A magnetic field is generated in exciting coil 1230 in the direction in correspondence with the direction of the current applied by AC power source 1502 through exciting coil 1230. In the drawing, the magnetic field generated rightward in the drawing in exciting coil 1230 induces an upward magnetic field in detecting coil 1250 and a downward magnetic field in detecting coil 1260. Conversely, the magnetic field generated leftward in the drawing in exciting coil 1230 induces a downward magnetic field in detecting coil 1250 and an upward magnetic field in detecting coil 1260 in the drawing. While the external magnetic field $H_0$ is applied in the fixed direction, the applied alternate magnetic field Hac is reversed in the polarity between the region $P_A$ in detecting coil 1250 and the region $P_B$ in detecting coil 1260 as illustrated in Fig. 14. Thereby, the bias effect of the external magnetic field $H_0$ is reversed between the positions $P_A$ and $P_B$.

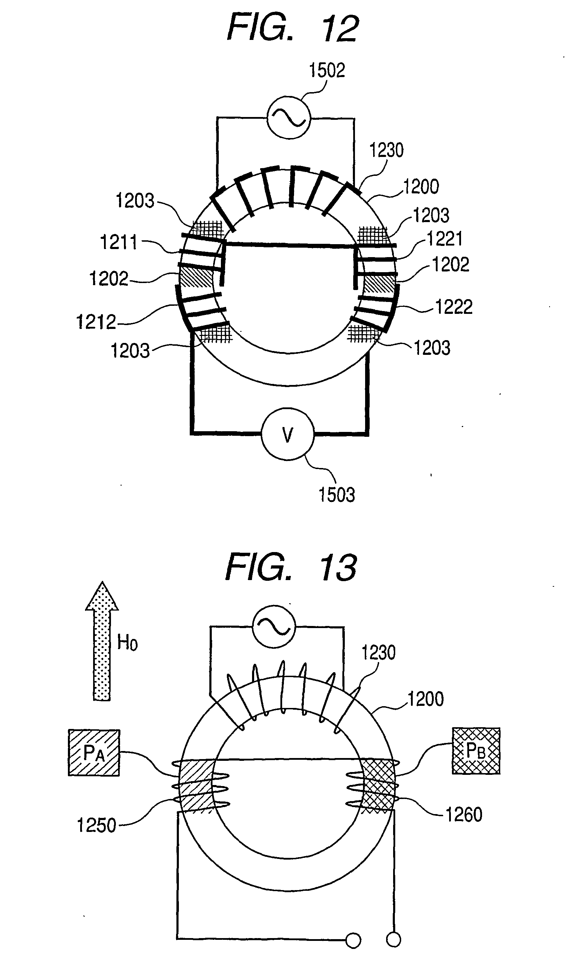

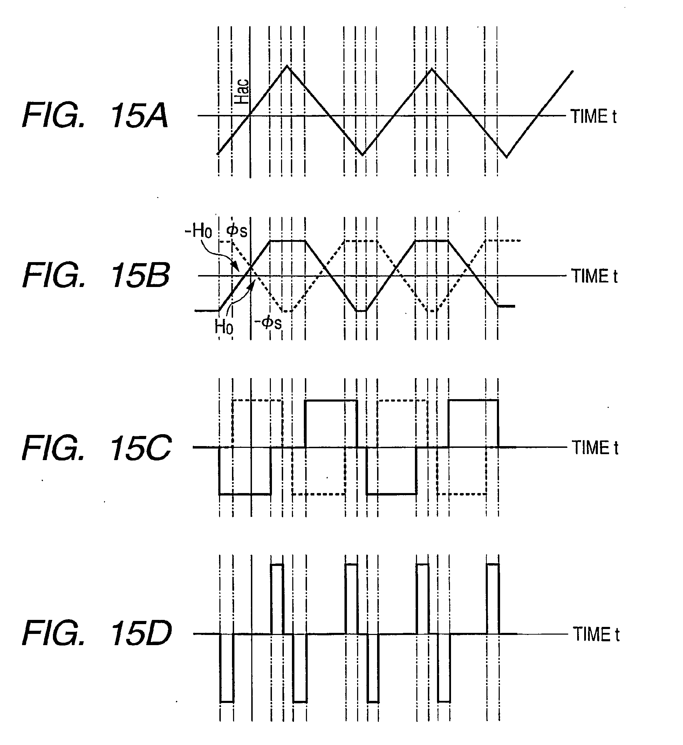

Figs. 15A to 15D are graphs illustrating the process of the magnetic field-detection output of the FG sensor element illustrated in Fig. 13. On application of the alternating magnetic field shown in Fig. 15A to exciting coil 1230, soft magnetic core 1200 is magnetized in the regions $P_A$ and $P_B$ as follows. With Hac and $H_0$ parallel to each other, the magnetization is saturated at Hac which is lower by $H_0$ than that at $H_0$=0. With Hac and $H_0$ antiparallel to each other, the magnetization of soft magnetic core 1200 is saturated at Hac which is higher by $H_0$ than that at $H_0$=0.

Accordingly, the magnetic fluxes $\Phi_A$ and $\Phi_B$ penetrating through detecting coils 1250, 1260 change with change of the magnetization with time as illustrated in Fig. 15B, where the full line indicates $\Phi_A$ and the dotted line indicates $\Phi_B$. Correspondingly, electromotive forces are induced in detecting coils 1250, 1260 as shown in Fig. 15C, where the full line indicates the electromotive force in coil 1250 and the dotted line indicates that of coil 1260. The total output is shown in Fig. 15D. From the deviation of the phase of the induced electromotive force (Fig. 15D) from the phase of Hac (Fig. 15A), the intensity of $H_0$ is detected as shown in Fig. 15B. Application of the reversed Hac to soft magnetic core 1200 as shown in Fig. 15A enables detection of the induced electromotive force at twice the frequency to remove the noise in measurement frequency to improve the S/N ratio. The parallel type FG sensors function in a similar operating principle even if the structure is different.

DISCLOSURE OF THE INVENTION

The parallel type of FG sensor element measures the magnetic field with an electric circuit containing soft magnetic core 1200, exciting coil 1230 and the detecting coil surrounding the core as descried in Non-Patent Document 6. An alternate current is allowed to flow through exciting coil 1230, and the change of the magnetic flux in detecting coils 1250, 1260 caused by magnetic change in soft magnetic core 1200 is detected as an induced electromotive force. In this detection, the magnetic field applied to soft magnetic core 1200 is the sum of the magnetic field to be detected and alternate magnetic field Hac applied by exciting coil 1230. Therefore, the change of magnetization in soft magnetic core 1200 varies depending on the relation between the magnetic field to be detected and Hac. By comparison of the output of the sensor before and after the immobilization of the magnetic particles, the magnetic particles can be detected by the magnetic field (Hs) generated by the magnetic particles.

In detection of a local magnetic field Hs generated by a magnetic particle by a parallel FG sensor element, a change of the relative position of the magnetic particle to the detecting coil can lower the sensor output as the result of counteraction in the induced electromotive force in the sensor element. Therefore, under some conditions, even in the presence of magnetic particles, the magnetic particles can not be detected owing to insufficient output of the sensor.

The present invention has been accomplished to solve the aforementioned problems of conventional techniques. The present invention intends to provide a magnetic detection element having improved sensitivity in detection of a magnetic field formed by a detection object substance, and a detection method therewith.

The present invention is directed to a magnetic detection element, comprising:

a core composed of a soft magnetic material, a detecting coil for detecting a magnetic field applied to the core, and an exciting coil for applying an alternating magnetic field to the core; wherein the surface of the core is divided into a first region and a second region in the longitudinal direction of the detecting coil, the first region and the second region being different in affinity for a detection object substance.

The present invention is directed to a magnetic detection element, comprising: a core composed of a soft magnetic material, a detecting coil for detecting a magnetic field applied to the core, and an exciting coil for applying an AC magnetic field to the core; wherein the detecting coil is comprised of two coils serially connected and wound in their respective winding directions reverse to each other, a first region and a second region are provided alternately from the one end of the detecting coil, the first region and the second region being different in affinity for a detection object substance.

In the magnetic detection element, a film can be provided on at least a portion of the first region, which film is comprised of a nonmagnetic material having a higher affinity for the detection object substance than the second region.

The present invention is directed to a detection method employing the magnetic detecting element, comprising: immobilizing the detection object substance on the surface of the magnetic detecting element, applying a static magnetic field for defining a magnetization direction of the detection object substance, applying the alternating magnetic field, and measuring with the magnetic detecting element the intensity of a signal generated in the detecting coil to detect the presence or concentration of the detection object substance.

The magnetization direction of the static magnetic field can be normal to the tangent plane at a position of immobilization of the detection object substance on the magnetic detecting element.

The detection object substance can be composed of a non-magnetizable substance, and a magnetic particle immobilized on the non-magnetizable substance.

The non-magnetizable substance can be a biological substance.

The detection object substance can be a magnetic substance.

The present invention enables increase of sensitivity for detection of a magnetic field caused by a magnetic particle in detection of a magnetic particle or a nonmagnetic substance labeled with a magnetic particle.

Further features of the present invention will become apparent from the following description of exemplary embodiments with reference to the attached drawings.

BRIEF DESCRIPTION OF THE DRAWINGS

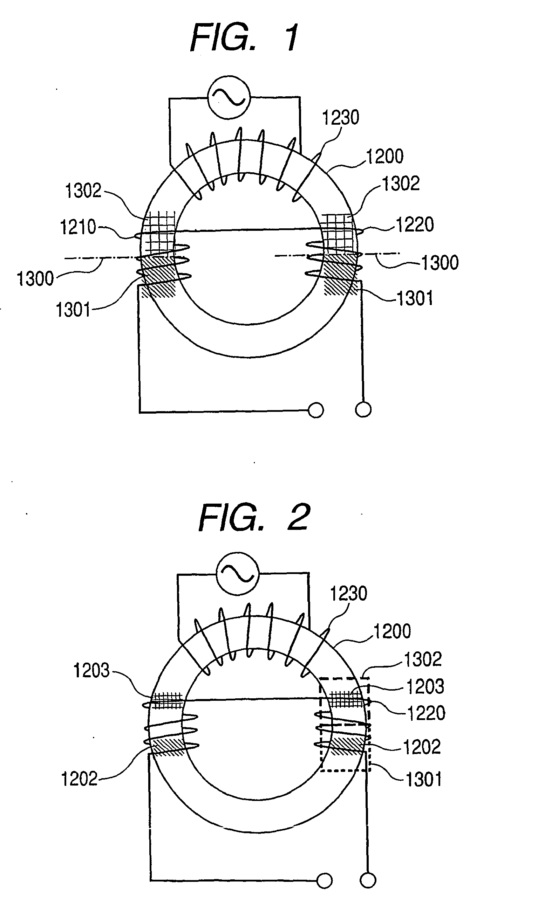

Fig. 1 is a schematic drawing for describing a constitution of an FG sensor element of the present invention.
Fig. 2 illustrates schematically an example of the FG sensor element described in Fig. 1.

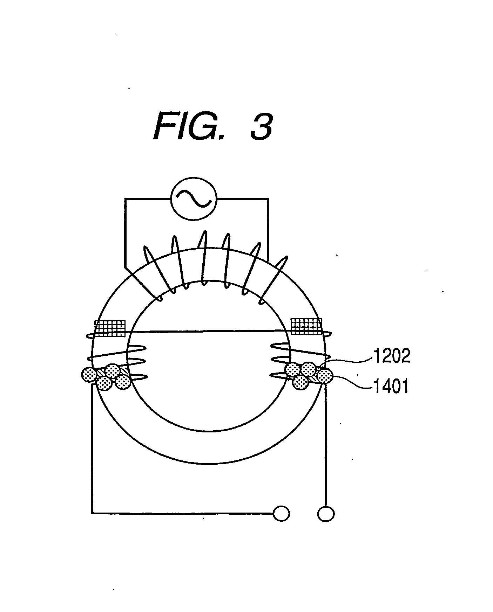

Fig. 3 illustrates schematically an example of immobilization of magnetic particles on the FG sensor element illustrated in Fig. 2.

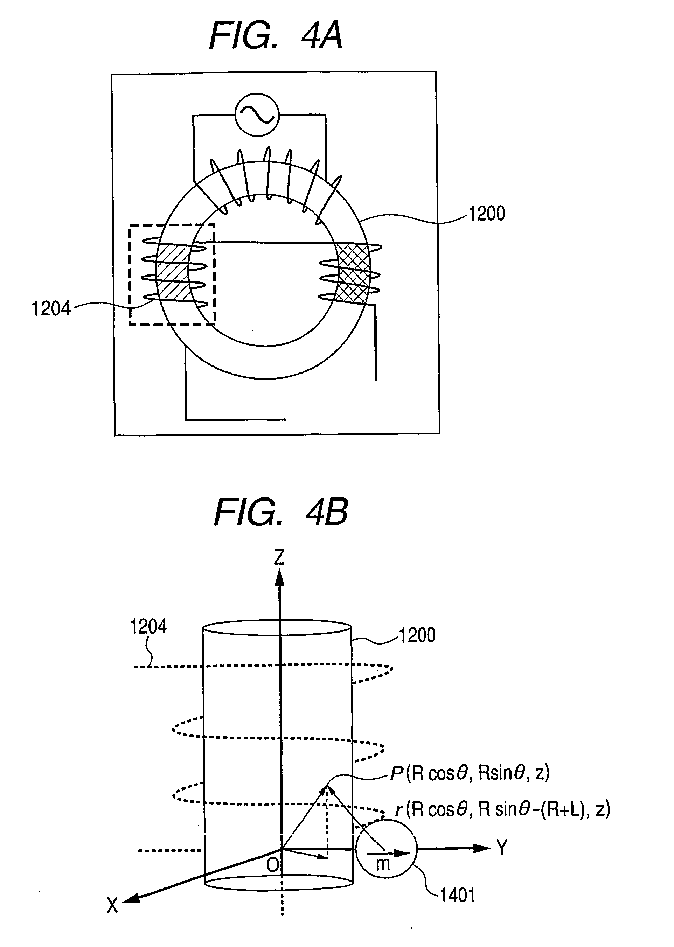

Figs. 4A and 4B are drawings for describing a coordinate for the magnetic particles immobilized on an FG sensor element.

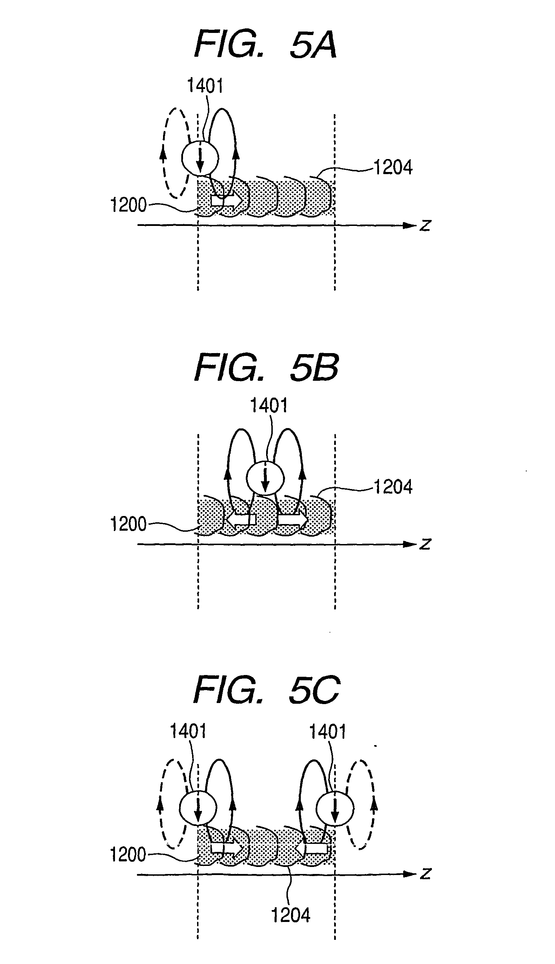

Figs. 5A, 5B and 5C are schematic drawings for illustrating a magnetic field applied to a conventional FG sensor element by the magnetic particles.

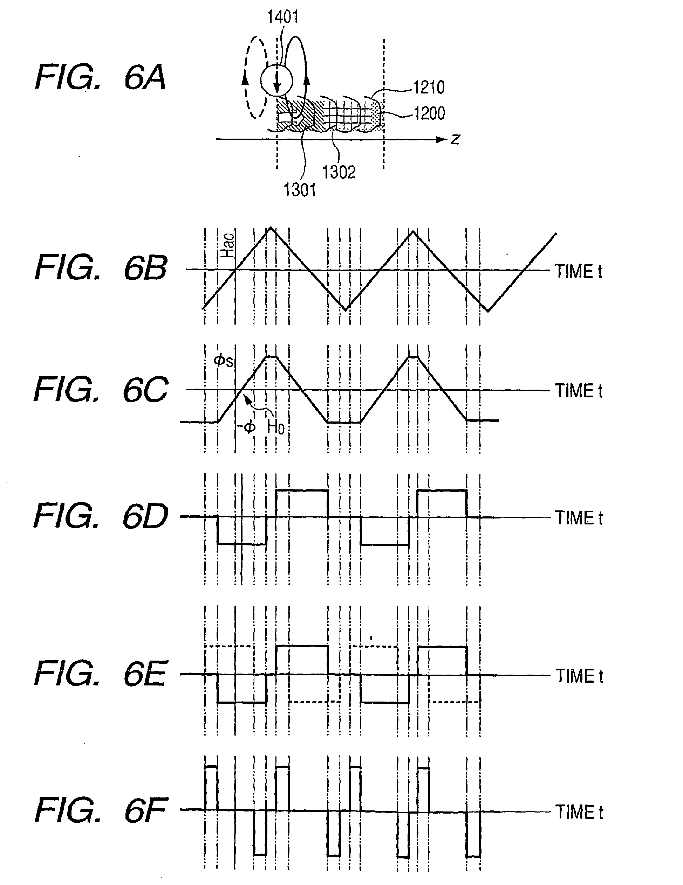

Figs. 6A, 6B, 6C, 6D, 6E and 6F include a schematic drawing of the FG sensor element and graphs showing the process for sensor element output in state I in Fig. 5A.

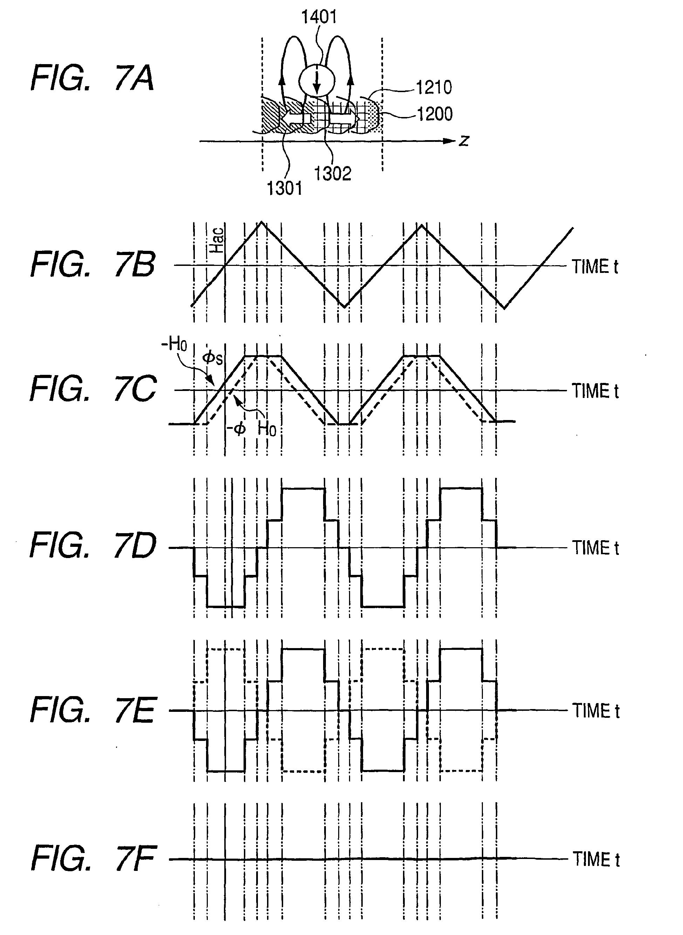

Figs. 7A, 7B, 7C, 7D, 7E and 7F include a schematic drawing of the FG sensor element and graphs showing the process for sensor element output in state II in Fig. 5B.

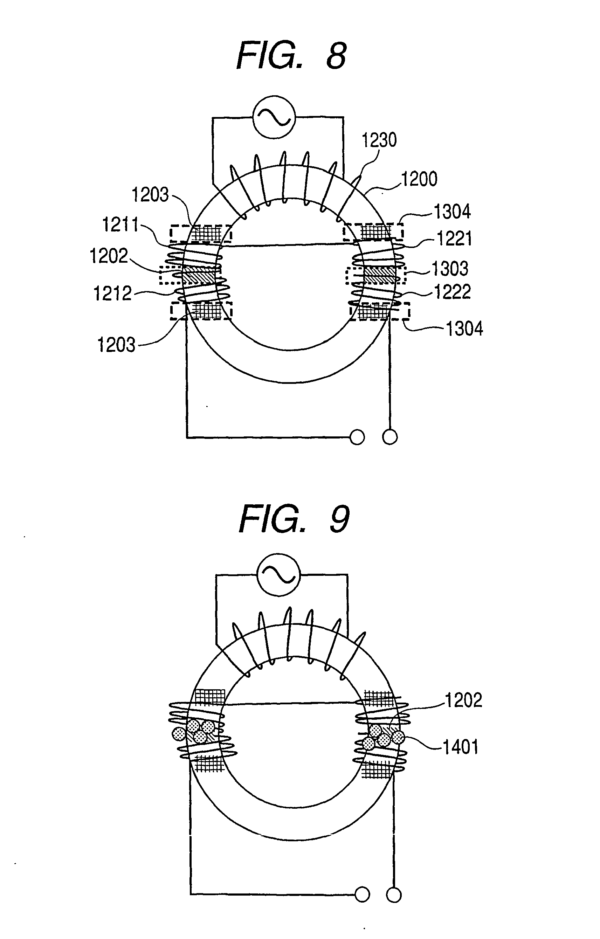

Fig. 8 illustrates schematically another constitution of the FG sensor element of the present invention.
Fig. 9 illustrates schematically an example of immobilization of magnetic particles on the FC sensor element illustrated in Fig. 8.

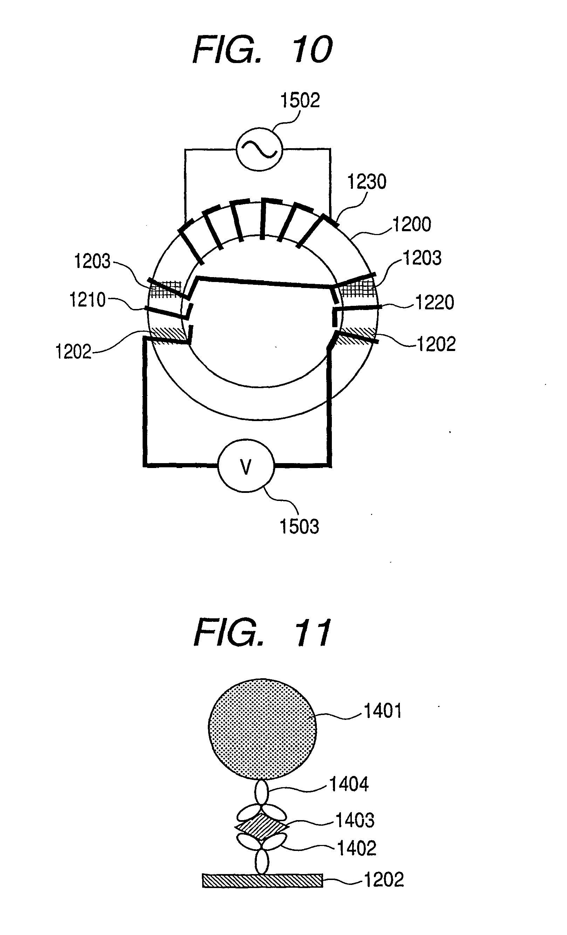

Fig. 10 illustrates schematically an external appearance of the parallel type FG sensor element of Example 1.
Fig. 11 illustrates a constitution of the detection object substance of Example 1.
Fig. 12 illustrates schematically an external appearance of the parallel type FG sensor element of Example 2.
Fig. 13 illustrates a constitution of the parallel type FG sensor element of Example 2.
Fig. 14 is a drawing for describing the operation principle of the FG sensor element.
Figs. 15A, 15B, 15C and 15D are graphs showing the process for output from the FG sensor element in Fig. 13.

BEST MODES FOR CARRYING OUT THE INVENTION

A constitution of a magnetic detection element of an embodiment of the present invention is described below. In this embodiment, the magnetic detection element is a parallel type FG sensor element.
Fig. 1 is a schematic drawing for describing a constitution of an FG sensor element of this embodiment. In Fig. 1, the FC sensor element comprises detecting coils 1210, 1220, soft magnetic core 1200, and exciting coil 1230 for applying an alternate magnetic field to the soft magnetic core 1200 in the longitudinal direction of the detecting coil. Detecting coils 1210, 1220 detect different intensities of signals in correspondence with the quantity of the magnetized substance to be detected.
Soft magnetic core 1200 is made of a soft magnetic material such as Permalloy composed of nickel (Ni) and iron (Fe), and Molybdenum Permalloy composed of Ni, Fe, and molybdenum (Mo).
The FG sensor element of this Embodiment of the present invention has the surface portions divided respectively into two regions 1301, 1302 by cross-sectional plane 1300 crossing the detecting coils 1210, 1220 respectively in the longitudinal direction. At least a part of region 1301 and at least a part of region 1302 are different in the affinity to a detection object substance. In this Embodiment, the detection object substance is a magnetic particle.
Fig. 2 illustrates schematically a constitution of the FG sensor described above with reference to Fig. 1. In Fig. 2, a magnetic particle-immobilizing film 1202 is formed which has a high affinity to a magnetic particle in the entire or a part of respective regions 1301, A magnetic particle-non-immobilizing film 1203 having an affinity lower than that of the magnetic particle-immobilizing film 1202 is formed in the entire or a part of respective regions 1302. The affinity may be changed gradually or locally between region 1301 and region 1302.
The films different in affinity to a magnetic particle can be formed by any of sputtering, plating, or vapor deposition on region 1301 and region 1302 on soft magnetic core 1200. Otherwise the affinity to the magnetic particle may be changed by controlling hydrophilicity or hydrophobicity of the films. The affinity to a magnetic particle can also be changed by changing the thickness of the same film. Further, the affinity to the magnetic particle may be changed by varying gradually the thickness or composition of the film formed on the surface of magnetic core 1200 between region 1301 and region 1302.
For example, a material highly affinitive to the magnetic particle is made thickest in a portion of region 1301. The film can be formed thicker locally by collimate sputtering.
The affinities of region 1301 and region 1302 to a magnetic particle are described above. However, the detection object substance is not limited to the magnetic particle, but may be a substance which can be immobilized to a magnetic particle. In this Embodiment, the affinity to the magnetic particle of region 1301 is assumed to be higher than that of region 1302. However, the relative affinity may be reversed between region 1301 and region 1302.

Fig. 3 illustrates schematically an example of immobilization of magnetic particles on the FC sensor element in Fig. 2. With the parallel type FG sensor element, magnetic particles 1401 can be immobilized on a part of the sensor element surface as illustrated schematically in Fig. 3. In Fig. 3, a plurality of magnetic particles 1401 are immobilized on magnetic particle-immobilizing film 1202.

One magnetic particle 1401 having magnetization "m" (represented by a vector) is detected by the FG sensor element by immobilization according to the principle described below with reference to Figs. 4A, 4B, 5A, 5B and 5C.

Figs. 4A and 4B are drawings for describing coordinates of the magnetic particles immobilized on a FG sensor element. Figs. 5A to 5C illustrate schematically a magnetic field applied to conventional FG sensor element by the magnetic particles. In Figs. 5A to 5C, the outlined white lateral arrow marks indicate directions of detectable component of the magnetic field Hs (represented by a vector) applied by the magnetic particles to the FG sensor element. The direction of the magnetization of the magnetic particles is controlled by a magnetic field-applying means (not shown in the drawing) for applying a DC magnetic field perpendicular to the alternating magnetic field. The means for applying DC-magnetic field may be a permanent magnet or an electromagnet, but is not limited thereto provided that the intended magnetic field can be applied.

With reference to Fig. 4A, the portion enclosed by the broken line of the FG sensor is considered. A position of a point P on the surface of soft magnetic core 1200 is indicated by three-dimensional coordinates. Strictly, in the element having a shape illustrated in Fig. 4A, the detecting coil portion of soft magnetic core 1200 is curved, not linear, in the longitudinal direction, but is approximated to be linear here. Further, for description as a general FG sensor, the detecting coil is denoted by a numeral 1204. Fig. 4B is an enlarged drawing of the portion enclosed by the broken line in Fig. 4A.

In Fig. 4B, the position of a point P on the surface of soft magnetic core 1200 is indicated by three-dimensional coordinates. The straight line passing the center of magnetic core 1200 in the longitudinal direction is taken as the Z-axis and a coordinate origin point O is defined at the position where the X-axis and Y-axis intersect. The position of the point P is represented by the coordinates (Rcosθ, Rsinθ, z), where R represents the radius of soft magnetic core 1200, and θ represents the angle, to the X axis, of the projection of the line segment connecting the point P with the origin point onto the XY coordinate plane. The vector of the distance r between the origin point and the magnetic particle 1401 at the point P on the surface of the soft magnetic core 1200 is represented by the vector (Rcosθ, Rsinθ-(R+L), z), where L represents the radius of magnetic particle 1401 placed on the Y-axis in the drawing. The floating magnetic field Hs is represented by Equation (1), where $\mu_0$ represents a vacuum magnetic permeability.

$$H_s = -\frac{1}{4\pi\mu_0 r^3}\left[m - \frac{3}{r^2}(mr)r\right] \quad \cdots\cdots\cdots\cdots\cdots (1)$$

$Hs_{sum}$ is derived by solving Equation (1), and taking the surface integral of the detectable magnetic field intensity |Hs (z)|of the element longitudinal direction.

State I is defined as the state in which a magnetic particle 1401 is immobilized at or around the end of detecting coil 1204 of the FG element as illustrated by Fig. 5A. State II is defined as the state in which magnetic particle 1401 is immobilized at or near the middle portion of detecting coil 1204. State I and State II are different greatly in the value of $Hs_{sum}$. In State II, as illustrated in Fig. 5B, the magnetic field applied from magnetic particle 1401 to soft magnetic core 1200 is reversed at the cross-sectional plane of the sensor element passing the point of contact of magnetic particle 1401 with the sensor element. In other words, in State I, the sensor element output is higher, whereas in State II sensor element output is attenuated greatly owing to integration of the bias effect of reversed Hs in the entire detecting coil 1204.

State III is defined as the state in which magnetic particles 1401 are located symmetrically with respect to the cross-sectional plane dividing equally detecting coil 1204 in the coil longitudinal direction (for example, at the both ends of the detecting coil in Fig. 5C). In detection of plural magnetic particles 1401 as illustrated in State III, similarly to State II, the bias effect of Hs counterbalances in the entire of detecting coil 1204. That is, the nearer to State II or State III, the more is the counterbalance in the entire element, whereby the output is lowered even if the magnetic particles are existing.

Next, the operation principle is described of the FG sensor of this Embodiment. Figs. 6A to 6F include a schematic drawing of the FG sensor element and graphs showing the process for sensor element output in State I in Fig. 5A. Fig. 6A illustrates schematically detecting coil 1210. In Fig. 6A, the lateral white arrow mark indicates the detectable component of the magnetic field Hs. In Figs. 6B and 6C, the vertical axes indicate the intensity of the magnetic field. In Figs. 6D to 6F, the vertical axes indicate the induced electromotive force produced in the detecting coil.

Region 1301 has higher affinity to magnetic particle 1401. Therefore, magnetic particle 1401 can be readily immobilized on region 1301. In this State I as illustrated in Fig. 6A, magnetic particle 1401 is located at the end of detecting coil 1210 in region 1301. In response to the magnetization change shown in Fig. 6B, the magnetic flux $\Phi$ in region 1301 changes with time as shown in Fig. 6C. The output of detecting coil 1210 is shown in Fig. 6D. Similarly detecting coil 1220 detects the magnetic field Hs of another magnetic field direction. Fig. 6E shows the output of coil 1210 by a full line and the output of coil 1220 by a dotted line. Fig. 6F shows the total of the outputs, sufficiently high.

Figs. 7A to 7F include a schematic drawing of the FG sensor element and graphs showing the process for sensor element output in State II in Fig. 5B. Fig. 7A illustrates schematically detecting coil 1210 in State II. In Fig. 7A, the lateral white arrow mark indicates the detectable component of the magnetic field Hs. In Figs. 7B and 7C, the vertical axes indicate the intensity of the magnetic field. In Figs. 7D to 7F, the vertical axes indicate the induced electromotive force produced in the detecting coil.

Fig. 7A illustrates schematically the FG sensor element in State II in which magnetic particle 1401 is located at the middle portion of detecting coil 1210 in region 1301. In response to the change of magnetization shown in Fig. 7B, the magnetic fluxes in regions 1301,1302 changes as shown in Fig. 7C, the output of coil 1210 changes as shown in Fig. 7D, and the outputs of coils 1210, 1220 change as shown in Fig. 7E. In Fig. 7E, the full line indicates the output of coil 1210, and the dotted line indicates the output of coil 1220. Region 1302 synchronizes with Hac, but is affected little by the magnetic field Hs of the magnetic particle. The outputs from detecting coil 1210 and detecting coil 1220 are counterbalanced to become zero.

The magnetic field, Hs, applied by the magnetic particle to the sensor element is considered by comparison of the outputs shown in Figs. 6A to 6F and in Figs. 7A to 7F. It is understood that the immobilization of magnetic particles 1401 to region 1301 is facilitated by providing region 1301 and region 1302 respectively in each of detecting coils 1210, 1220 as shown in Fig. 1, and a high output can be obtained by immobilizing magnetic particle 1401 at or near one end of respective detecting coils 1210 and 1220.

In this Embodiment, a portion having a strong affinity for the detection object substance is provided at least a part of one of the two divisional regions of the detecting coil. Therefore, in measurement of the magnetic field produced by the detection object substance, the magnetic particle is immobilized onto the portion having strong affinity for the detection object substance, which facilitates detection of the magnetic field of the magnetic particle with a high intensity of the signal corresponding to the magnetic field.

Next, another constitution of the FG sensor of the Embodiment of the present invention is described. Fig. 8 illustrates another constitution of the FG sensor element of this Embodiment. The same symbols as in Fig. 1 are used for denoting the corresponding elements without definition. In this Embodiment also, the detection object is a magnetic particle.

As illustrated in Fig. 8, the FG sensor element comprises detecting coils 1211, 1212, 1221, 1222; soft magnetic core 1200; and exciting coil 1230 for applying an alternating magnetic field to soft magnetic core 1200 in the coil longitudinal direction. Detecting coils 1211, 1212, 1221, 1222 detect signals different in the intensity in accordance with the quantity of the magnetized detection object.

Detecting coil 1211 and detecting coil 1212 are connected in series, but are reversed in the coil winding direction. Detecting coil 1221 and detecting coil 1222 are connected in series, but are reversed in the coil winding direction. Detecting coil 1211 and detecting coil 1221 are also reversed in the coil winding direction.

The film on the surface of soft magnetic core 1200 detecting coil 1211 and that of detecting coil 1212 are different between the region 1303 and region 1304. Region 1304 is provided at the respective end portions of detecting coils 1211, 1212, and region 1303 is provided at the connection portion between the two coils. In Fig. 8, region 1303 is indicated by a short-gapped broken line, and region 1304 is indicated by a long-gapped broken line. Region 1303 is located at the portion where the coil winding direction is reversed between coil 1211 and detecting coil 1212. The location of region 1303 and region 1304 is the same in relation to detecting coils 1221 and 1222.

In a series of four detecting coils 1212, 1211, 1221, 1222, the regions between the coils and at the end of the coils are considered. Region 1304 is located at the end portion of detecting coil 1212: region 1303 is located at the connection portion between detecting coil 1212 and detecting coil 1211. Region 1304 is placed at the connection portion between detecting coil 1211 and detecting coil 1221, region 1304 being divided into two fractions in Fig. 8. Region 1303 is placed at the connection portion between detecting coil 1221 and detecting coil 1222, and region 1304 is placed at the end side of detecting coil 1222.

As mentioned above, at the connection portions or the end sides of the coils in series on the surface of soft magnetic core 1200, regions 1303 and region 1304 are provided alternately from the end of the coil series. Region 1303 corresponds to the first region of the present invention, and region 1304 corresponds to the second region of the present invention.

Region 1303 is different from at least a part of region 1304 in the affinity for the detection object substance. At a part or the entire of region 1303, magnetic particle-immobilizing film 1202 is formed which has higher affinity for the magnetic particle. At a part or the entire of region 1304, magnetic particle-non-immobilizing film 1203 is formed which has lower affinity for the magnetic particle than magnetic particle-immobilizing film 1202. The affinity may be changed gradually along the element surface between region 1301 and region 1302, or locally at a portion of the surface.

The affinities of region 1303 and of region 1304 for the magnetic particle are described above. However, the detection object substance is not limited to the magnetic particle, but may be a substance which can be immobilized onto the magnetic particle. In the description below, region 1303 is assumed to have affinity for the magnetic particle higher than region 1304, but the relative affinity of the region 1303 and region 1304 may be reversed.

The detection operation of detecting coils 1211, 1221 of the FG sensor element illustrated in Fig. 8 is not described here in detail, since the operation can be conducted in the same manner described with reference to Figs. 6A to 6F. With the element illustrated in Fig. 8, detecting coils 1212, 1222 also give the output as described above with reference to Figs. 6A to 6F like detecting coils 1211, 1221. With the FG sensor element illustrated in Fig. 8 also, a high output of the sensor element can be achieved for magnetic particle 1401 according to the aforementioned operation principle.

In Fig. 8, detecting coils 1211, 1212 connected in series are employed in place of detecting coil 1210 illustrated in Fig. 1, and detecting coils 1221, 1222 connected in series are employed in place of detecting coil 1220 illustrated in Fig. 1. However, the number of the coils provided on the portions corresponding to detecting coils 1210, 1220 is not limited to be two, but may be more than two. In use of detecting coils of more than two, the coil winding direction is reversed alternately between the adjacent coils, and detecting coil may overlap the coil end or region 1303 at the coil border.

In actual detection of magnetic particle 1401, the magnetic fields of the magnetic particles 1401 are aligned in one direction by applying an external magnetic field or other means to realize the state simulated in the above calculation model. In particular, the saturation of the sensitivity can be avoided by applying a static magnetic field in the detection-difficulty direction. In particular, in Figs. 5A to 5C, the magnetic field is applied in the direction normal to the plane of the element in contact with the detection object at the immobilization position, for the consideration. In this Embodiment and in Example described later, the term "detection-difficulty direction" signifies a magnetic field containing a component of magnetic field in a direction other than the detection direction. The term "a magnetic field in the direction normal" signifies a magnetic field having a component in the normal direction. The term "face of the element" signifies a surface containing protection film or the like formed around the element.

Under the conditions shown in Figs. 6A to 6F, magnetic particle 1401 can be detected at a high sensor element output by detection of the magnetic field of magnetic particle 1401. Even if the number of magnetic particles 1401 is small, the detection can be made with sufficient output in comparison with a conventional detection method.

Fig. 9 illustrates schematically an example of immobilization of magnetic particles on an FG sensor. With the aforementioned parallel type FG sensor element, magnetic particles 1401 can be immobilized onto a portion of the sensor element surface. In Fig. 9, a plurality of magnetic particles 1401 are immobilized on magnetic particle-immobilizing film 1202.

In this Embodiment, two or more coils different in the winding direction are connected in series. A portion having higher affinity and a portion having lower affinity for the detection object substance are provided alternately at the connection portion and end portions of the detecting coils. Thereby, in measurement of the magnetic field produced by the detection object substance, the magnetic particles are immobilized at the portions having higher affinity for the detection object substance to facilitate the detection of the magnetic field produced by the magnetic particles to give high signal output in accordance with the magnetic field.

The magnetic detection element and the detection method employing the element of the present invention improves the sensitivity in detection of the magnetic field produced by the magnetic particles in detection of magnetic particles or a nonmagnetic substance labeled with magnetic particles.

The magnetic detection element of the present invention comprises a soft magnetic core, a detecting coil for detecting a magnetic field applied to the core, and an exciting coil for applying an alternate magnetic field to the detecting coil. The magnetic detecting element may have a constitution for the properties of the surface of the core of the detecting coil for solving the aforementioned problems.

Specifically, the magnetic detection element has a first region and a second region in the longitudinal direction of the detecting coil, the first region and the second region being made different from each other in the surface property. The difference in the surface property includes difference in affinity for the magnetic particles as the detection object substance. The difference in the surface property may be difference in flatness of the surface, insofar as the regions are different in ease of adhesion of a detection object substance.

<EXAMPLE 1>

This Example describes an immunological sensor employing a magnetic detection element and a detection method of the present invention.

(i) Sensor Mechanism

The constitution of the FG sensor element of this Example is described below. Fig. 10 illustrates schematically an external view of the parallel type FG sensor element of this Example. As illustrated in Fig. 10, soft magnetic core 1200 has exciting coil 1230, detecting coils 1210, 1220 for detecting magnetic change in thin-filmed soft magnetic core 1200.

The process for producing the FG sensor element of this Example is described briefly below. In this Example, the FG sensor element is produced through a semiconductor production process. A nonmagnetic material such as $SiO_2$ is placed on soft magnetic core 1200, and detecting coils 1210, 1220, and exciting coil 1230 are wound around the soft magnetic core. The material for the soft magnetic core is exemplified by FeCo alloys.

Before winding the coils, a first region and a second region are defined on the element surface for each of detecting coils 1210, 1220 by dividing the coil into two portions in the coil longitudinal direction by a cross-sectional plane as illustrated in Fig. 10. The first region corresponds to region 1301 illustrated in Fig. 1, and the second region corresponds to region 1302 illustrated in Fig. 2. On a part of the respective first regions (near the one end of the detecting coil in Fig. 10), a gold film is formed as magnetic particle-immobilizing film 1202. On a part of the respective second regions (near the other end of the detecting coil in Fig. 10), a SiN film is formed as magnetic particle-non-immobilizing film 1203.

(ii) Immobilization of Magnetic Particles

A constitution of the detection object substance is described. Fig. 11 illustrates a constitution of the detection object substance of this Example. The detection object substance comprises antigen 1403 (nonmagnetic substance), a magnetic particle 1401, and secondary antibody 1404 for bonding antigen 1403 to magnetic particle 1401. Antigen 1403 is connected through primary antibody 1402 to magnetic particle-immobilizing film 1202. Thereby the detection object substance is immobilized on magnetic particle-immobilizing film 1202.

With the above-mentioned magnetic detecting element (FG sensor element), prostate-specific antigen (PSA) is detected which is known as a marker for prostate cancer, according to the protocol below. A primary antibody for recognizing the PSA is preliminarily immobilized on soft magnetic core 1200 of the FG sensor element.

(1) A phosphate-buffered physiological saline (test object solution) containing PSA as the antigen (test object) is injected into a flow path, and is incubated for 5 minutes;
(2) A phosphate-buffered physiological saline is allowed to flow through the flow path to remove any unreacted PSA;
(3) Another phosphate-buffered saline containing anti-PSA antibody (secondary antibody) labeled with magnetic particle 1401 is injected into the flow path, and is incubated for 5 minutes; and
(4) An unreacted labeled antibody is washed off by a phosphate buffered physiological saline.

According to the above protocol, magnetic particle 1401 is immobilized through anti-PSA antibody (secondary antibody) 1404, antigen 1403, and primary antibody 1402 on magnetic particle-immobilizing film 1202 in the first region provided on the surface of magnetic core 1200 of the FG sensor element. In the absence of antigen 1403 in the test object, magnetic particle 1401 is not immobilized on magnetic core 1200 of the element. Therefore the presence of the antigen can be detected by detecting the presence of immobilized magnetic particle 1401.

(iii) Measurement Procedure

An external magnetic field is applied perpendicularly to the film face of the thin film ring core of soft magnetic core 1200 in the detection-difficulty direction of the FG sensor element. Thereby the magnetization of magnetic particle 1401 immobilized on magnetic particle-immobilizing film 1202 on the first region is aligned in the direction perpendicular to the film face. AC power source 1502 illustrated in Fig. 10 is actuated to generate alternate magnetic field of 1 MHz in exciting coil 1230. The generated alternating magnetic field is applied to soft magnetic core 1200. The electromotive force induced in serially connected detecting coils 1210, 1220 is measured by the detection signal indicated by the potential difference between the ends of the detecting coil.

The difference of the phase of the detection signals from the phase of the AC magnetic field indicates the presence of magnetic particle 1401. From the extent of the phase difference, the quantity of immobilized magnetic particles 1401 can be estimated, and the quantity of antigen 1403 contained in the detection object can be estimated indirectly. Further, the concentration of antigen 1403 in the test object can be estimated from the quantity.

In the operation of the above item (ii) in this Example, one flow path only is employed, but plural flow paths may be provided in the detection section to cause different antigen-antibody reactions in the respective flow paths to detect plural antigens simultaneously.

<EXAMPLE 2>

This Example describes application of the constitution illustrated in Fig. 8 to the element in Example 1. Fig. 12 illustrates schematically the external view of the parallel type FG sensor of this Example.

As illustrated in Fig. 12, the FG sensor of this Example comprises, detecting coils 1211, 1212 and detecting coils 1221, 1222 which are reversely wound and provided in series in the FG sensor of Example 1. On the surface of the soft magnetic core 1200 of the portions of detecting coil 1211, 1212 connected in series, region 1303 and region 1304 like the ones illustrated in Fig. 8 are provided. The same regions are provided also on the surface of soft magnetic core 1200 of detecting coils 1221, 1222.

Magnetic particle-immobilizing film 1202 is formed at least a part of the region corresponding to region 1303, and magnetic particle-non-immobilizing film 1203 is formed at least a part of the region corresponding to region 1304. In the measurement, the magnetic field is measured which is caused by the magnetic particle, the magnetic field caused by magnetic particle 1401 immobilized on magnetic particle-immobilizing film 1202. The mobilization of the magnetic particles and the measurement are conducted in the same manner as in Example 1. Therefore the detail thereof is not described here.

The FG sensor element described in above Examples 1 and 2 are not limited to those having a thin-filmed ring core, but may be another parallel type FG sensor.

While the present invention has been described with reference to exemplary embodiments, it is to be understood that the invention is not limited to the disclosed exemplary embodiments, but by the scope of the following claims.

**Claims**

1. A magnetic detection element, comprising:

   a core (1200) composed of a soft magnetic material,
   a detecting coil (1210, 1220) for detecting a magnetic field applied to the core, and
   an exciting coil (1230) for applying an alternating magnetic field to the core; **characterised in that**
   the surface of the core is divided into a first region (1301) and a second region (1302) in the longitudinal direction of the detecting coil, the first region and the second region being different in affinity for a detection object substance.

2. A magnetic detection element, comprising:

   a core (1200) composed of a soft magnetic material,
   a detecting coil (1210, 1220) for detecting a magnetic field applied to the core, and
   an exciting coil (1230) for applying an AC magnetic field to the core; **characterised in that**
   the detecting coil is comprised of two coils serially connected and wound in their respective winding directions reverse to each other,
   a first region (1301) and a second region (1302) are provided in the surface of the core alternately from the one end of the detecting coil, the first region and the second region being different in affinity for a detection object substance.

3. The magnetic detection element according to claim 1 or 2, wherein a film (1202, 1203) is provided on at least a portion of the first region, which film is comprised of a nonmagnetic material having a higher affinity for the detection object substance than the second region.

4. A detection method employing the magnetic detecting element set forth in any one of claims 1 to 3, comprising:

   immobilizing the detection object substance on the surface of the magnetic detecting element,
   applying a static magnetic field for defining a magnetization direction of the detection object substance,
   applying the alternating magnetic field, and
   measuring with the magnetic detecting element the intensity of a signal generated in the detecting coil to detect the presence or concentration of the detection object substance.

5. The detection method according to claim 4, wherein the magnetization direction of the static magnetic field is normal to the tangent plane at a position of immobilization of the detection object substance on the magnetic detecting element.

6.  The detection method according to claim 4 or 5, wherein the detection object substance is composed of a non-magnetizable substance, and
    a magnetic particle immobilized on the non-magnetizable substance.

7.  The detection method according to claim 6, wherein the non-magnetizable substance is a biological substance.

8.  The detection method according to claim 4 or 5, wherein the detection object substance is a magnetic substance.

**Patentansprüche**

1.  Magnetisches Detektierelement, umfassend:

    einen Kern (1200), aufgebaut aus einem weichmagnetischen Material,
    eine Detektierspule (1210, 1220) zum Detektieren eines an den Kern angelegten Magnetfeldes, und
    eine Erregerspule (1230) zum Anlegen eines magnetischen Wechselfeldes an den Kern;
    **dadurch gekennzeichnet, dass**
    die Oberfläche des Kerns, in Längsrichtung der Detektierspule, in einen ersten (1301) und einen zweiten Bereich (1302) unterteilt ist, wobei sich der erste und der zweite Bereich bezüglich der Affinität zu einer zu detektierenden Objekt-Substanz unterscheiden.

2.  Magnetisches Detektierelement, umfassend:

    einen Kern (1200), aufgebaut aus einem weichmagnetischen Material,
    eine Detektierspule (1210, 1220) zum Detektieren eines an den Kern angelegten Magnetfeldes, und
    eine Erregerspule (1230) zum Anlegen eines magnetischen Wechselfeldes an den Kern;
    **dadurch gekennzeichnet, dass**
    die Detektierspule aufgebaut ist aus zwei in Reihe geschalteten Spulen, welche in ihrem je zugehörigen Wicklungssinn gegensinnig zueinander gewickelt sind, und
    ein erster (1301) und ein zweiter Bereich (1302) abwechselnd vom einen Ende der Detektierspule auf der Oberfläche des Kerns vorgesehen sind, wobei sich der erste und der zweite Bereich bezüglich der Affinität zu einer zu detektierenden Objekt-Substanz unterscheiden.

3.  Element nach Anspruch 1 oder 2, wobei eine Schicht (1202, 1203) zumindest auf einem Teil des ersten Bereichs vorgesehen ist und ein unmagnetisches Material mit höherer Affinität zur zu detektierenden Objekt-Substanz als der zweite Bereich umfasst.

4.  Detektierverfahren, welches das magnetische Detektierelement nach einem der Ansprüche 1 bis 3 verwendet, umfassend:

    Immobilisieren der zu detektierenden Objekt-Substanz auf der Oberfläche des magnetischen Detektierelements,
    Anlegen eines statischen Magnetfeldes zur Definition einer Magnetisierungsrichtung der zu detektierenden Objekt-Substanz,
    Anlegen des magnetischen Wechselfeldes, und
    Messen der Intensität eines in der Detektierspule erzeugten Signals mithilfe des magnetischen Detektierelements, um das Vorhandensein oder die Konzentration der zu detektierenden Objekt-Substanz zu detektieren.

5.  Verfahren nach Anspruch 4, wobei
    die Magnetisierungsrichtung des statischen Magnetfeldes senkrecht zur Tangentialebene an einer Immobilisierungsposition der zu detektierenden Objekt-Substanz auf dem Magnetdetektierelement verläuft.

6.  Verfahren nach Anspruch 4 oder 5, wobei die zu detektierende Objekt-Substanz aufgebaut ist aus einer unmagnetisierbaren Substanz und einem auf der unmagnetisierbaren Substanz immobilisierten Magnetpartikel.

7.  Verfahren nach Anspruch 6, wobei die unmagnetisierbare Substanz eine biologische Substanz ist.

8.  Verfahren nach Anspruch 4 oder 5, wobei die zu detektierende Objekt-Substanz eine magnetische Substanz ist.

**Revendications**

1.  Elément de détection magnétique, comprenant :

    un noyau (1200) composé d'une substance faiblement ferromagnétique,
    une bobine de détection (1210, 1220) pour détecter un champ magnétique appliqué au noyau, et
    une bobine d'excitation (1230) pour appliquer un champ magnétique alternatif au noyau ; **caractérisé en ce que**
    la surface du noyau est divisée en une première région (1301) et une deuxième région (1302) dans la direction
    longitudinale de la bobine de détection, la première région et la deuxième région étant différentes en termes
    d'affinité pour une substance d'un objet de détection.

2.  Elément de détection magnétique, comprenant :

    un noyau (1200) composé d'une substance faiblement ferromagnétique,
    une bobine de détection (1210, 1220) pour détecter un champ magnétique appliqué au noyau, et
    une bobine d'excitation (1230) pour appliquer un champ magnétique AC au noyau ; **caractérisé en ce que**
    la bobine de détection est composée de deux bobines connectées en série et enroulées dans leurs directions
    d'enroulement respectives l'une à l'inverse de l'autre,
    une première région (1301) et une deuxième région (1302) sont prévues de manière alternée dans la surface
    du noyau à partir de l'extrémité de la bobine de détection, la première région et la deuxième région étant
    différentes en termes d'affinité pour une substance d'un objet de détection.

3.  Elément de détection magnétique selon la revendication 1 ou 2, dans lequel un film (1202, 1203) est prévu sur au
    moins une partie de la première région, lequel film est composé d'un matériau amagnétique présentant une plus
    grande affinité pour la substance d'un objet de détection que la deuxième région.

4.  Procédé de détection employant l'élément de détection magnétique selon l'une quelconque des revendications 1
    à 3, comprenant le fait :

    d'immobiliser la substance d'un objet de détection sur la surface de l'élément de détection magnétique,
    d'appliquer un champ magnétique statique pour définir une direction d'aimantation de la substance d'un objet
    de détection,
    d'appliquer le champ magnétique alternatif, et
    de mesurer avec l'élément de détection magnétique l'intensité d'un signal généré dans la bobine de détection
    pour détecter la présence ou la concentration de la substance d'un objet de détection.

5.  Procédé de détection selon la revendication 4, dans lequel la direction d'aimantation du champ magnétique statique
    est normale au plan tangent à une position d'immobilisation de la substance d'un objet de détection sur l'élément
    de détection magnétique.

6.  Procédé de détection selon la revendication 4 ou 5, dans lequel la substance d'un objet de détection est composée
    d'une substance non magnétisable, et
    une particule magnétique immobilisée sur la substance non magnétisable.

7.  Procédé de détection selon la revendication 6, dans lequel la substance non magnétisable est une substance
    biologique.

8.  Procédé de détection selon la revendication 4 ou 5, dans lequel la substance d'un objet de détection est une
    substance magnétique.

## FIG. 1

## FIG. 2

# FIG. 3

1202

1401

## FIG. 4A

## FIG. 4B

$P$(R cos$\theta$, Rsin$\theta$, z)

$r$(R cos$\theta$, R sin$\theta$-(R+L), z)

*FIG. 5A*

*FIG. 5B*

*FIG. 5C*

FIG. 6A

FIG. 6B

FIG. 6C

FIG. 6D

FIG. 6E

FIG. 6F

*FIG. 7A*

1401

1210

1200

1301   1302

z

*FIG. 7B*

Hac

TIME t

*FIG. 7C*

-H₀

φs

-φ   H₀

TIME t

*FIG. 7D*

TIME t

*FIG. 7E*

TIME t

*FIG. 7F*

TIME t

## FIG. 8

## FIG. 9

# FIG. 10

1502

1230

1200

1203

1203

1210

1220

1202

1202

1503

# FIG. 11

1401

1404

1403

1402

1202

# FIG. 12

# FIG. 13

# FIG. 14

FIG. 15A

Hac

TIME t

FIG. 15B

-H₀ | Φs

H₀  -Φs

TIME t

FIG. 15C

TIME t

FIG. 15D

TIME t

**EP 2 165 190 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005315744 A
- JP 2006208368 A

**Non-patent literature cited in the description**

- **H. A. Ferreira et al.** *J. Appl. Phys.,* 2003, vol. 93, 7281
- **Pierre-A. Besse et al.** *Appl. Phys. Lett.,* 2002, vol. 80, 4199
- **SeungKyun Lee et al.** *Appl. Phys. Lett.,* 2002, vol. 81, 3094
- **Richard Luxton et al.** *Anal. Chem.,* 2001, vol. 16, 1127
- **Horia Chiriac et al.** *J. Magn. Magn. Mat.,* vol. 293, 671
- Zikikohgaku no Kiso to Oyoh. *Denki Gakkai magnetics Technology Committee,* 171
- Base and Application of Magnetic Engineering. *The Institute of Electrical Engineers of Japan, Magnetics Technology Committee,* 171